# EUROPÄISCHE PATENTSCHRIFT

(11) **EP 3 435 205 B1**
(45) Veröffentlichungstag und Bekanntmachung des Hinweises auf die Patenterteilung: **12.02.2020**
(21) Anmeldenummer: 18182820.3
(22) Anmeldetag: 11.07.2018
(51) Int. Cl.: G06F 3/01, G06F 3/041, G06F 3/044, B32B 7/00, H01L 41/09, H01L 41/193, F03G 7/00, H01L 51/00, H01L 41/047, B60Q 3/74, B60Q 3/14

(54) **FOLIE MIT FUNKTIONSSCHICHT UND HAPTISCHER RÜCKMELDUNG**
FILM WITH FUNCTIONAL LAYER AND HAPTIC FEEDBACK
FEUILLE POURVUE DE COUCHE FONCTIONNELLE ET DE RÉPONSE HAPTIQUE

(30) Priorität: 26.07.2017 DE 102017116867
(43) Veröffentlichungstag der Anmeldung: 30.01.2019
(73) Patentinhaber: Dr. Schneider Kunststoffwerke GmbH, 96317 Kronach Bayern (DE)
(72) Erfinder: Schinzler, Claus, 96317 Kronach (DE); Hüttel, Bernd, 95119 Naila (DE); Schmidt, Klaus, 95362 Kupferberg (DE)

(56) Entgegenhaltungen:
- WO-A1-2009/158074
- WO-A1-2010/115549
- US-A1- 2012 105 333

## Beschreibung

Es wird eine Folie mit einer Funktionsschicht und haptischer Rückmeldung beschrieben, wobei die Funktionsschicht mindestens zwei beabstandet gegenüberliegende Elektroden aufweist, die jeweils in einer elektrisch leitenden Schicht angeordnet oder durch diese gebildet sind.

Eine solche Folie kann als Beschichtung auf ein Verkleidungsteil aufgebracht werden und dabei verschiedene Konturen aufweisen. Zusätzlich können über die Folie eine oder mehrere Bedieneingaben erfasst und die Bedieneingaben von einer Steuereinheit, die mit der Folie signaltechnisch verbunden ist, ausgewertet werden. Die Folie kann nach einer Bedieneingabe eine haptische Rückmeldung liefern, sodass für eine Bedienperson die erfolgreiche Bedieneingabe wahrnehmbar ist, ohne, dass beispielsweise optische oder akustische Rückmeldungen gegeben werden müssen.

Eine solche Folie kann beispielsweise in Fahrzeugen eingesetzt werden. Fahrzeuge umfassen Kraftfahrzeuge, wie PKW, LKW oder Busse, Züge, Flugzeuge oder Schiffe.

Die Folie kann insbesondere verschiedene Konturen abbilden. Die Folie kann eine Bedien- und Steueroberfläche für verschiedene Bedieneingaben zur Steuerung von Klimatisierungseinrichtungen, Medieneinrichtungen und weiteren Einrichtungen bereitstellen.

### Stand der Technik

Aus dem Stand der Technik sind verschiedene Schichtaufbauten mit mehreren Folien und Baugruppen bekannt.

Aus WO 2009/158074 A1 sind Systeme und Verfahren zur Bereitstellung eines haptischen Feedbacks auf einer berührungsempfindlichen Oberfläche bekannt, wobei ein Schichtaufbau für eine berührungsempfindliche Oberfläche mit haptischer Rückmeldung eine Aktivierungsschicht aufweist, die elektroaktive Polymere aufweisen kann. Zusätzlich weist der Schichtaufbau eine Abstandsschicht sowie zwei hierüber getrennte elektrisch leitende Schichten auf.

WO 2009/158074 A1 offenbart zur Bereitstellung eines Schichtaufbaus mit haptischer Rückmeldung und berührungsempfindlicher Oberfläche, wobei die Oberflächen des Schichtaufbaus geschützt sind, einen Aufbau mit einer ersten und einer zweiten Schutzschicht, welche den Schichtaufbau an den Oberflächen abschließen, sowie drei elektrisch leitenden Schichten, wobei eine erste elektrisch leitende Schicht von einer zweiten elektrisch leitenden Schicht durch eine Abstandsschicht und die zweite elektrisch leitende Schicht von einer dritten elektrisch leitenden Schicht durch eine elektroaktive Polymerschicht getrennt sind.

Der darin gezeigte Schichtaufbau weist jedoch mehrere Schichten zur Bereitstellung der verschiedenen Funktionen auf.

Hierüber ergeben sich teilweise sehr große Schichtdicken. Sollen beispielsweise noch weitere Funktionen bzw. Effekte über einen solchen Aufbau erzielt werden, nimmt der Schichtaufbau an Höhe zu.

US 2015/0153886 A1 offenbart einen Touchscreen mit einer Sensorschicht, in der ein Sensorelement aufgenommen ist. Über dieses Sensorelement können Bedieneingaben erfasst werden. Über dem Sensorelement ist eine weitere Schicht angeordnet, welche elektroaktive Polymere aufweist. Über die dazugehörigen Elektrodenschichten der weiteren Schicht mit den elektroaktiven Polymeren kann eine Verformung der weiteren Schicht erfolgen. Hierzu ist die weitere Schicht in dem Bereich, welcher verformt werden kann, nicht mit der darunterliegenden Sensorschicht verbunden. Da das Sensorelement und die Sensorschicht nicht verformbar sind, kann keine Betätigung durch Aufbringen von Druck erfolgen.

US 2015/0169118 A1 offenbart eine Anordnung mit einem Touchscreen, der zwischen einer starren, unflexiblen Schutzplatte und einem Display-Panel angeordnet ist. Der Touchscreen umfasst eine erste Elektrode und eine zweite Elektrode, wobei zwischen diesen eine Schicht angeordnet ist, die elektroaktive Polymere aufweist. Diese Schicht dient als Abstandsschicht zwischen den Elektroden und ist unflexibel ausgebildet, wobei für die Schicht eine Dotierung erfolgt, um die Ansteuerspannung für die elektroaktiven Polymere herabzusetzen und die Festigkeit der Schicht zu erhöhen. Die Elektroden ermöglichen sowohl ein Erfassen von Bedienbefehlen als Sensorelemente als auch eine Ansteuerung zur Aktivierung der elektroaktiven Polymere, wobei über die elektroaktiven Polymere Vibrationen erzeugt werden können. Eine Betätigung durch Aufbringen von Druck kann durch die Anordnung von US 2015/0169118 A1 ebenfalls nicht erfolgen.

### Aufgabe

Demgegenüber besteht die Aufgabe darin eine Folie mit einer Funktionsschicht und haptischer Rückmeldung anzugeben, wobei der Schichtaufbau gegenüber bekannten Systemen reduziert ist und auf eine Anordnung mit einer Vielzahl verschiedener Baugruppen verzichtet wird, wodurch die Folie beliebig verformt und für verschiedene Einsatzgebiete verwendet werden kann und eine Betätigung für eine Bedienperson haptisch wahrnehmbar ist.

### Lösung

Die Aufgabe wird durch eine Folie mit einer Funktionsschicht und haptischer Rückmeldung gelöst, wobei die Funktionsschicht mindestens zwei beabstandet gegenüberliegende Elektroden aufweist, wobei eine Elektrode in einer ersten elektrisch leitenden Schicht und eine Elektrode in einer zweiten elektrisch leitenden Schicht angeordnet oder durch diese gebildet sind, aufweisend folgenden Schichtaufbau:
- eine erste Oberflächenschicht,
- die erste elektrisch leitende Schicht,
- eine Abstandsschicht,
- die zweite elektrisch leitende Schicht, und
- eine zweite Oberflächenschicht,
wobei
- die Abstandsschicht elektroaktive Polymere aufweist,
- die Abstandsschicht zwischen der ersten elektrisch leitenden Schicht und der zweiten elektrisch leitenden Schicht angeordnet ist,
- über die Elektroden der ersten elektrisch leitenden Schicht und der zweiten elektrisch leitenden Schicht Bedieneingaben durch eine Kapazitätsänderung aufgrund der Veränderung des Abstandes der elektrisch leitenden Schichten erfassbar sind, und
- die erste Oberflächenschicht und die erste elektrisch leitende Schicht zur Erzeugung einer haptischen Rückmeldung nach einer Bedieneingabe zur Wahrnehmung einer erfolgreichen Betätigung über die elektroaktiven Polymere verformbar sind, wobei über die elektroaktiven Polymere durch Anlegen einer Spannung Erhebungen und/oder Vertiefungen in der ersten Oberflächenschicht erzeugt werden.

Die Folie zeichnet sich durch einen einfachen Aufbau mit einer geringen Schichtdicke aus. Es wird eine Folie mit einer geschlossenen Oberfläche bereitgestellt, wobei keine Montage einer Vielzahl von Baugruppen und Schichten erforderlich ist. Bisher ist die Realisierung verschiedener Funktionen nur mit mehreren Komponenten umsetzbar, wobei die hierin beschriebene Folie sämtliche Funktionen in einer Folie mit dem Schichtaufbau zusammenfasst. Gegenüber dem Stand der Technik wird eine geringere Schichtdicke der Folie dadurch erreicht, dass die Abstandsschicht zwischen den elektrisch leitenden Schichten elektroaktive Polymere aufweist.

Bei Schichtaufbauten aus dem Stand der Technik waren bisher eine Abstandsschicht sowie eine gesonderte Schicht aus elektroaktiven Polymeren notwendig, um sowohl eine Erfassung von Bedieneingaben als auch eine haptische Rückmeldung bereitstellen zu können. Bei der Funktionsschicht mit den mindestens zwei beabstandet gegenüberliegenden Elektroden, wobei entweder Elektroden in den Schichten eingebracht sind oder mindestens eine dieser Schichten als Elektrode fungiert, wird zur Erfassung von Bedienbefehlen in der Regel die erste elektrisch leitende Schicht relativ zur zweiten elektrisch leitenden Schicht bewegt, wodurch sich Änderungen hinsichtlich der Kapazität in diesem Bereich ergeben, welche in einer Steuereinheit erfasst und als Bedienbefehl verarbeitet werden können. Die Abstandsschicht zwischen zwei elektrisch leitenden Schichten aus dem Stand der Technik wird in der Regel aus Freiräumen in beispielsweise einer dünnen Kunststoffschicht bereitgestellt. Um eine haptische Rückmeldung liefern zu können war es im Stand der Technik dann noch notwendig, eine weitere Schicht vorzusehen. Die hierin beschriebene Folie verbindet die Abstandsschicht mit einer Schicht für eine haptische Rückmeldung, wobei der Schichtaufbau der Folie erheblich reduziert ist. Die Folie ermöglicht daher sowohl eine Erfassung von Bedienbefehlen durch Veränderung der Kapazität der Funktionsschicht, wobei auch eine Wahrnehmung einer Bedieneingabe durch einen Benutzer derart erfolgt, dass die Folie in diesem Bereich durch die Abstandsschicht verformt wird, als auch die Bereitstellung einer haptischen Rückmeldung über die elektroaktiven Polymere.

Die Abstandsschicht kann ionische elektroaktive Polymere oder elektrische elektroaktive Polymere aufweisen. Ionische elektroaktive Polymere werden durch den Massentransport von Molekülen und Ionen zu einer Bewegung gezwungen. Elektrische aktive Polymere werden durch elektrische Felder bewegt, wobei sich eine Kunststoffschicht zwischen zwei dünnen Elektrodenschichten beim Anlegen einer Spannung zusammenziehen und damit das dazwischen angeordnete Polymer dehnen kann. Ionische elektroaktive Polymere weisen gegenüber elektrischen elektroaktiven Polymeren eine größere Reaktionszeit und geringere Aktivierungsspannung sowie eine geringere Dehnbarkeit auf. Die Abstandsschicht der hierin beschriebenen Folie kann insbesondere dielektrische elektroaktive Polymere (dEAP) aufweisen. Dielektrische EAPs weisen ein isolierendes, dehnbares Material (Dielektrikum) auf, das zu beiden Seiten mit einem dünnen elektrisch leitenden Werkstoff (Elektroden) beschichtet ist. Beispielsweise können die dielektrischen EAPs thermoplastische Elastomere (TPE) umfassen.

Zwischen der zweiten elektrisch leitenden Schicht und der zweiten Oberflächenschicht kann eine Beleuchtungsschicht angeordnet sein. Eine Beleuchtungsschicht ermöglicht die Bereitstellung einer Beleuchtung für Bereiche der Funktionsschicht, wobei die Beleuchtung durch die Folie hindurch erfolgt, sodass die Oberfläche an entsprechenden Positionen beleuchtbar ist.

Hierbei kann die Beleuchtungsschicht vollflächig eine Beleuchtung oder partiell eine Beleuchtung bereitstellen. Beispielsweise kann die Beleuchtungsschicht lichtausbringende Elemente aufweisen oder über ein Beleuchtungselement beleuchtbar sein. Die Beleuchtungsschicht kann dabei als Lichtleiter dienen. Damit eine partielle Beleuchtung möglich ist ergibt sich neben der Ausbildung von einzelnen Beleuchtungselementen die Möglichkeit einer Beschichtung der Oberfläche, welche die zu beleuchtenden Bereiche freilässt. Alternativ kann auch die Oberflächenschicht mit einer entsprechenden Struktur ausgebildet sein oder Zusätze aufweisen, welche die Transparenz festlegen lassen.

Zwischen der zweiten elektrisch leitenden Schicht und der Beleuchtungsschicht kann eine zweite Abstandsschicht angeordnet sein. Eine zweite Abstandsschicht kann eine sehr geringe Schichtdicke aufweisen, da lediglich eine Trennung der zweiten elektrisch leitenden Schicht von der Beleuchtungsschicht und gegebenenfalls darin integrierten elektrischen Komponenten erfolgen soll. Die zweite Abstandsschicht muss nicht, wie die erste Abstandsschicht, mit den elektroaktiven Polymeren eine Bewegung der beiden Schichten relativ zueinander zulassen.

Die Beleuchtungsschicht kann lichtemittierende Dioden (LED) oder organische lichtemittierende Dioden (OLED) aufweisen oder als Lichtleiter ausgebildet sein. Über LEDs oder OLEDs lassen sich Bereiche der Folie in verschiedenen Farben beleuchten, wobei zusätzlich über OLEDs beispielsweise eine Umschaltung erreicht werden kann, wobei die Beleuchtungsschicht zwischen transparent und undurchsichtig umschaltbar ist.

In weiteren Ausführungsformen kann auch eine Beleuchtungsschicht aus OLEDs unterhalb der ersten Oberflächenschicht angeordnet sein, sodass die darunterliegenden Schichten entweder transparent oder undurchsichtig schaltbar sind. Die Schicht mit solchen OLEDs ist ebenfalls flexibel ausgebildet und ermöglicht daher eine Verformung der Folie, ohne dass die Funktionalität und die haptische Rückmeldung beeinträchtigt werden. Insbesondere ergibt sich durch die Flexibilität eine Übertragung von Bedienbefehlen durch eine Bewegung der beiden elektrisch leitenden Schichten relativ zueinander.

Die Abstandsschicht und/oder die erste elektrisch leitende Schicht und die zweite elektrisch leitende Schicht können mindestens abschnittsweise in Segmente unterteilt sein. Durch Anlegen einer Spannung verändern sich die Polymere. Hierdurch kommt es zu einem Zusammenziehen bzw. einer Verhärtung. Durch Aufteilung der Folie in Segmente ist dabei ein Muster darstellbar. Hierbei werden nur bestimmte Bereiche der Folie durch die elektroaktiven Polymere bei einer haptischen Rückmeldung aktiviert. Entsprechend können dann auch die dazugehörigen elektrisch leitenden Schichten in Segmente unterteilt sein. Es kann jedoch auch eine Segmentierung der Abstandsschichten mit den elektroaktiven Polymeren und die Erzeugung von Mustern erfolgen, wobei diesem Muster nur ein einziges Bedienfeld zugeordnet ist.

Die erste elektrisch leitende Schicht und die zweite elektrisch leitende Schicht können eine Vielzahl von Elektroden aufweisen, die gegenüberliegend in der ersten elektrisch leitenden Schicht und der zweiten elektrisch leitenden Schicht angeordnet sind. Alternativ zur Bereitstellung einer rein elektrisch leitenden Schicht, wobei die gesamte Schicht als Elektrode wirkt, können auch einzelne Elektroden in den Schichten angebracht sein. Die Kontaktierung kann beispielsweise über in die Schichten eingearbeitete Metallfäden erfolgen.

Die Abstandsschicht kann eine Vielzahl von Polymerelementen aufweisen, die beabstandet zueinander angeordnet sind. Hierüber ist es möglich nur bestimmte Bereiche der Folie zu aktivieren, um eine haptische Rückmeldung für diese Bereiche zu erreichen. Da sich elektroaktive Polymere in Abhängigkeit der an ihnen anliegenden Spannung zusammenziehen bzw. wieder ihren Ausgangszustand einnehmen, lassen sich verschiedene Strukturen, Muster oder andere Oberflächenbeschaffenheiten durch Erhebungen realisieren. Beispielsweise kann eine Anzahl von Polymerelementen aktiviert werden, nachdem eine bestimmte Benutzereingabe erfolgt ist, welche über die elektrisch leitenden Schichten aufgenommen und durch eine Steuereinheit erkannt wurde, wobei die Aktivierung der entsprechenden Polymerelemente für die Dauer einer Aktvierung einen Zustand signalisiert, der von einer Person durch Berührung erfasst werden kann. Beispielsweise lassen sich hierüber auch Stellungen von Schiebeschaltern, Drehstellern oder Bedienknöpfen realisieren.

Die Polymerelemente können insbesondere disgruent oder kongruent zu den Elektroden in der ersten leitenden Schicht und den Elektroden in der zweiten leitenden Schicht angeordnet sein.

Befinden sich die Polymerelemente beispielsweise disgruent zu Elektroden in den elektrisch leitenden Schichten, so kann zwischen diesen Polymerelementen eine Lücke bestehen. Diese Lücke ermöglicht schon bei der Betätigung eine haptische Rückmeldung durch einen Benutzer, da dieser Bereich wahrnehmbar verformt d. h. nach unten gedrückt werden kann. Beispielsweise wird die Folie über eine Beleuchtungsschicht so beleuchtet, dass bestimmte Bedienfelder in einer bestimmten Farbe über die Oberfläche dargestellt werden. Wählt eine Bedienperson eine Bedienfunktion aus und drückt auf diesen Bereich, so erfolgt eine Verformung der Folie in diesem Bereich für die Dauer der Kraftbeaufschlagung durch den Benutzer. Anschließend kann eine Veränderung der Farbe dieses Bedienfelds erfolgen, wobei über die elektroaktiven Polymere zusätzlich eine Verformung der Oberfläche für einen bestimmbaren Zeitraum erfolgt. In weiteren Ausführungsformen kann zusätzlich über eine Steuereinheit und damit verbundene Lautsprechereinheiten ein akustisches Signal ausgegeben werden.

Die elektroaktiven Polymere in der Abstandsschicht können zudem einen Schichtaufbau aus einer Vielzahl von elektroaktiven Polymeren aufweisen, um eine definierbare Verformung erreichen zu können. In der Regel werden mehrere solcher elektroaktiven Polymere übereinandergelegt, damit die auftretende Verformung eine entsprechende Vergrößerung der Schichtdicke der Folie an der ersten Oberfläche bereitstellt.

Durch eine Time-Multiplexschaltung kann bei der Abstandsschicht mit den elektroaktiven Polymeren auch eine Verformung der elektroaktiven Polymere über eine Bedieneingabe der Benutzer erreicht werden, wobei die elektroaktiven Polymere in diesem Fall als Abstandselemente zur Verlagerung der Elektroden der ersten elektrisch leitenden Schicht und der zweiten elektrisch leitenden Schicht für eine Nutzereingabe verformt werden. Anschließend können die elektroaktiven Polymere zumindest in diesem Bereich aktiviert werden, wobei dann eine Vergrößerung der Oberfläche in diesem Bereich erfolgen kann.

Die elektroaktiven Polymere können auch in einem flüssigen bzw. zähflüssigen Zustand, beispielsweise in in der Abstandsschicht angeordneten Kammern aufgenommen sein, wobei die Schicht derart flexibel ist, dass bei einem Druck auf diese Kammern die Flüssigkeit mit den elektroaktiven Polymeren nachgibt und dabei eine Bewegung der elektrisch leitenden Schichten zueinander zulässt, wobei die Kammern entsprechend flexibel ausgebildet sind. Beispielsweise kann die gesamte elektroaktive Schicht mit den Kammern flexibel ausgebildet sein.

Weitere Vorteile, Merkmale sowie Ausgestaltungsmöglichkeiten ergeben sich aus der nachfolgenden Figurenbeschreibung von nicht einschränkend zu verstehenden Ausführungsbeispielen.

### Kurzbeschreibung der Figuren

In den Zeichnungen zeigt:
- Fig. 1: eine schematische Darstellung des Schichtaufbaus einer Folie einer ersten Ausführungsform;
- Fig. 2: eine schematische Darstellung des Schichtaufbaus einer Folie einer zweiten Ausführungsform;
- Fig. 3: eine schematische Darstellung des Schichtaufbaus einer Folie einer dritten Ausführungsform;
- Fig. 4: eine schematische Darstellung des Schichtaufbaus einer Folie einer vierten Ausführungsform;
- Fig. 5: eine schematische Darstellung des Schichtaufbaus der Folie der vierten Ausführungsform während einer Bedieneingabe;
- Fig. 6: eine schematische Darstellung des Schichtaufbaus der Folie der vierten Ausführungsform nach einer Bedieneingabe mit haptischer Rückmeldung; und
- Fig. 7: eine schematische Darstellung des Schichtaufbaus einer Folie einer fünften Ausführungsform nach einer Bedieneingabe mit haptischer Rückmeldung.

In den Zeichnungen mit gleichen Bezugszeichen versehene Komponenten entsprechen im Wesentlichen einander, sofern nichts anderes angegeben ist. Darüber hinaus wird darauf verzichtet Bestandteile zu beschreiben und zu zeigen, welche nicht wesentlich zum Verständnis der hierin offenbarten technischen Lehre sind.

### Ausführliche Beschreibung von Ausführungsbeispielen

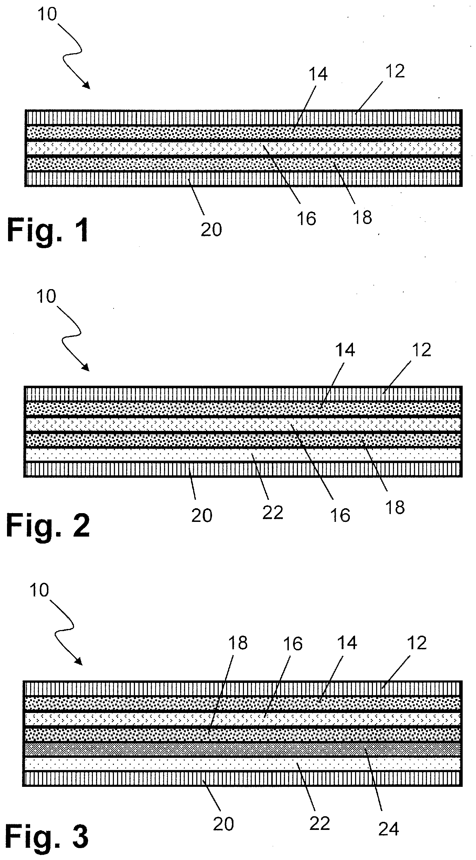

Fig. 1 zeigt eine schematische Darstellung des Schichtaufbaus einer Folie 10 einer ersten Ausführungsform. Die Folie 10 weist einen Schichtaufbau mit einer Oberflächenschicht 12, einer elektrisch leitenden Schicht 14, einer Abstandsschicht 16, einer elektrisch leitenden Schicht 18 und einer Oberflächenschicht 20 auf. Die Folie 10 kann beispielsweise in Kraftfahrzeugen einen Bereich eines Armaturenbretts überdecken und eine Bedienoberfläche bereitstellen. In weiteren Ausführungsformen kann eine Folie 10 auch an anderen Positionen, beispielsweise im Bereich einer Seitenwandverkleidung eines Fahrzeugs oder im Bereich eines Fahrzeugdachs angeordnet sein. Die Folie 10 ermöglicht es durch kapazitive Messungen Bedienbefehle eines Nutzers zu erfassen und an eine Steuereinheit, die mit den elektrisch leitenden Schichten 14 und 18 gekoppelt ist, zu übermitteln, wobei sich hierüber dann Steuerungsbefehle für daran angeschlossene Einheiten ergeben.

Die Folie 10 ist so ausgebildet, dass diese leicht verformt werden kann. Im Stand der Technik weisen derartige Folien oftmals einen Aufbau mit mehreren Komponenten sowie daran angeordnete Baugruppen auf. Die Folie mit den daran angeordneten Baugruppen kann daher oftmals nur schlecht verformt werden, wodurch sich die Einsatzgebiete stark beschränken. Weiterhin weisen solche Folien aus dem Stand der Technik durch die daran angeordneten Baugruppen in der Regel eine sehr große Dicke auf. Zudem ist die Rückseite oftmals nicht geschützt, was zu einer Beschädigung der Funktionsschichten führen kann.

Die hierin beschriebene Folie 10 der ersten Ausführungsform weist an den Oberflächen eine Oberflächenschicht 12 und eine Oberflächenschicht 20 auf, welche die dazwischen aufgenommenen Schichten schützen. Beispielsweise bestehen die Oberflächenschichten 12 und 20 aus einer dünnen flexiblen Folie aus einem Kunststoff. In weiteren Ausführungsformen kann auch eine derartige Kunststoffschicht auf die weiteren Schichten aufgebracht werden.

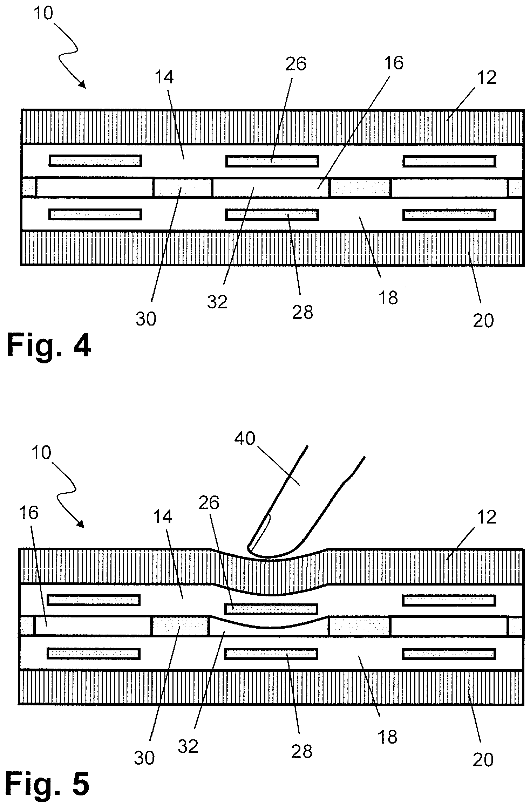

Die elektrisch leitenden Schichten 14 und 18 können beispielsweise vollflächig als Elektroden dienen und entsprechend ausgebildet sein. Daher ist es möglich, durch eine Veränderung des Abstands der elektrisch leitenden Schichten 14 und 18 zueinander eine Änderung der Kapazität und hieraus einen Steuerbefehl für eine damit gekoppelte Einheit zu erfassen. In weiteren Ausführungsformen können die elektrisch leitenden Schichten 14 und 18 auch Elektroden 26 und 28 aufweisen (siehe hierzu Fig. 4 bis 7).

Die Abstandsschicht 16 weist elektroaktive Polymere auf. Beispielsweise können ionische elektroaktive Polymere oder elektrische elektroaktive Polymere, insbesondere dielektrische elektroaktive Polymere, vorgesehen sein. Die elektroaktiven Polymere in der Abstandsschicht 16 erlauben eine Verlagerung der beiden elektrisch leitenden Schichten 14 und 18 zueinander, sodass eine Bedieneingabe erfassbar ist. Zudem können die elektroaktiven Polymere in der Abstandsschicht 16 durch Anlegen einer Spannung sich zusammenziehen, was zu einer Veränderung der Schichthöhe der Abstandsschicht 16 führt.

Hierbei wird darauf hingewiesen, dass bei einer Erstreckung der elektroaktiven Polymere und hierzu angeordneten dünnen Elektroden, welche sich in Längsrichtung parallel zu den elektrisch leitenden Schichten 14 und 18 erstrecken, eine Verringerung der Schichtdicke in diesem Bereich erfolgt. Eine haptische Rückmeldung nach einer Bedieneingabe kann daher anstelle einer Erhebung in diesem Bereich zu einer Vertiefung führen. Um jedoch eine Erhebung zu erreichen, können elektroaktive Polymere in der Abstandsschicht 16 auch so angeordnet werden, dass sich beispielsweise die dünnen Elektrodenwände orthogonal zu den Schichten erstrecken. Solche Ausführungen betreffen alle in den Figuren gezeigten Ausführungsformen. Darüber hinaus können die elektrisch leitenden Schichten 14 und 18, welche anders als in den Figuren dargestellt, eine sehr geringe Schichtdicke aufweisen, sowohl als Elektroden zur Erfassung von Bedieneingaben als auch als Elektroden für die elektroaktiven Polymere in der Abstandsschicht 16 dienen. Eine Verlagerung der elektrisch leitenden Schichten 14 und 18 relativ zueinander bewirkt daher die Erfassung einer Bedieneingabe, durch eine Veränderung der Kapazität zwischen den beiden elektrisch leitenden Schichten 14 und 18. Zudem kann durch Anlegen einer Spannung an den elektrisch leitenden Schichten 14 und 18 ein Zusammendrücken der dazwischen angeordneten Polymere bewirkt werden. Die Funktionsschicht mit den elektrisch leitenden Schichten 14 und 18 sowie der Abstandsschicht 16 weist in solchen Ausführungen einen sehr dünnen Aufbau auf und ermöglicht sowohl die Erfassung von Benutzereingaben als auch eine haptische Rückmeldung.

Eine derartige Ausführung, wobei die elektrisch leitenden Schichten 14 und 18 als Elektroden für die in der Abstandsschicht 16 aufgenommenen Polymere dienen, gilt in entsprechender Weise auch für die weiteren Ausführungen der Fig. 2 bis 7 und dementsprechend können auch die darin gezeigten Funktionsschichten derart ausgebildet sein.

Fig. 2 zeigt eine schematische Darstellung des Schichtaufbaus einer Folie 10 einer zweiten Ausführungsform. Diese weist zusätzlich eine Beleuchtungsschicht 22 auf. Die Beleuchtungsschicht 22 kann beispielsweise als Lichtleiter ausgebildet sein, wobei durch eine seitliche Lichteinbringung, beispielsweise durch eine Leuchtdiode, die komplette Beleuchtungsschicht 22 illuminiert wird. Damit lediglich Bereiche mit Blick auf die Oberflächenschicht 12 leuchten, kann diese nur teilweise transparent ausgebildet sein. Dies kann durch Zusätze in der Oberflächenschicht 12 oder durch definiertes Freilegen von Bereichen oder Einbringen von Schablonen erfolgen.

Die Beleuchtungsschicht 22 kann auch organische lichtemittierende Dioden (OLED) aufweisen. Diese ermöglichen neben einer Beleuchtung in verschiedenen Bereichen, wobei eine Vielzahl von derartigen OLEDs vorgesehen sein kann, auch eine verschiedenfarbige Beleuchtung. Zudem ist es in Abhängigkeit der Ansteuerung möglich, die Beleuchtungsschicht 22 transparent oder undurchsichtig umzuschalten. Eine solche Beleuchtungsschicht 22 kann beispielsweise dann auch zwischen der Oberflächenschicht 12 und der ersten elektrisch leitenden Schicht 14 vorgesehen sein, sodass bei einem Transparentschalten darunter befindliche Bereiche und Schichten, wie beispielsweise eine zusätzliche Beleuchtungsschicht 22, sichtbar sind.

Fig. 3 zeigt eine schematische Darstellung des Schichtaufbaus einer Folie 10 in einer dritten Ausführungsform. Bei der dritten Ausführungsform ist zwischen der zweiten elektrisch leitenden Schicht 18 und der Beleuchtungsschicht 22 eine zweite Abstandsschicht 24 angeordnet. Die zweite Abstandsschicht 24 trennt die elektrisch leitende Schicht 18 von einer Beleuchtungsschicht 22, welche beispielsweise elektronische Komponenten enthält. Die zweite Abstandsschicht 24 dient dabei als Dielektrikum zwischen der Schicht 18 und der Beleuchtungsschicht 22. Ist die Beleuchtungsschicht 22 als Lichtleiter ausgebildet, so ist keine Abstandsschicht 24 erforderlich, sodass ein Aufbau wie für Fig. 2 gezeigt ausreichend sein kann.

Als Dielektrikum für die zweite Abstandsschicht 24 können ebenfalls dünne Kunststoffschichten verwendet werden.

Fig. 4 zeigt eine schematische Darstellung des Schichtaufbaus einer Folie 10 in einer vierten Ausführungsform. Fig. 4 zeigt einen vergrößerten Ausschnitt, wobei in den elektrisch leitenden Schichten 14 und 18 einzelne Elektroden 26 und 28 aufgenommen sind, die beispielsweise über dünne Metallfäden kontaktierbar sind. In weiteren nicht gezeigten Ausführungsformen können die elektrisch leitenden Schichten 16 und 18 selbst vollständig als Elektroden dienen.

Bei der vierten Ausführungsform weist die Abstandsschicht 16 Polymerelemente 30 auf, die jeweils als elektroaktive Polymere ausgebildet sind. Diese sind beabstandet zueinander angeordnet, sodass zwischen zwei Polymerelemente 30 eine Lücke 32 besteht. Zudem können sich die Polymerelemente 30 derart in der Abstandsschicht 16 erstrecken, dass die Elektroden sich orthogonal zu der Abstandsschicht 16 erstrecken und gegenüberliegend zu weiteren Polymerelementen 30 ausgebildet sind. In der vierten Ausführungsform erfolgt daher eine Kontaktierung der Polymerelemente 30 nicht über die elektrisch leitenden Schichten 14 und 18, welche die Elektroden 26 und 28 aufweisen, sondern über die gegenüberliegenden Elektroden, die sich orthogonal zu den Elektroden 28 und 26 erstrecken. Die Polymerelemente 30 lassen sich daher unabhängig voneinander ansteuern, wobei insbesondere auch eine Benutzereingabe für definierte Bereiche über die Elektroden 26 und 28 erfassbar ist. In der in Fig. 4 gezeigten Ausführungsform sind die Polymerelemente 30 disgruent zu den Elektroden 26 und 28 angeordnet.

Fig. 5 zeigt eine schematische Darstellung des Schichtaufbaus der Folie 10 der vierten Ausführungsform während einer Bedieneingabe. Bei einer Bedieneingabe drückt eine Bedienperson mit einem Finger 40 auf den Bereich der Oberflächenschicht 12 der Folie 10, welcher beispielsweise über eine nicht dargestellte Beleuchtung einen für ihn relevanten Bereich markiert. Die Bedienperson drückt mit dem Finger 40 auf diesen Bereich, wodurch aufgrund der Lücken 32, die einen Abstand zwischen den Polymerelementen 30 bereitstellen, eine Verformung der Oberflächenschicht 12 und eine Verformung der elektrisch leitenden Schicht 14 erfolgt. Dies führt zu einer Veränderung des Abstands zwischen den Elektroden 26 und 28 was als Kapazitätsänderung über eine damit verbundene Steuereinheit erfasst und als Bedienbefehl verstanden wird.

Die elektrisch leitende Schicht 14 und die Oberflächenschicht 12 sind flexibel ausgebildet. Nach dem Auswählen eines Bedienbefehls gehen die elektrisch leitende Schicht 14 und die Oberflächenschicht 12 in ihre Ausgangsstellung zurück. Der Bedienbefehl wurde jedoch über die Steuereinheit bereits erfasst und führt zu einer entsprechenden Aktion über damit verbundene Einheiten. Zudem gibt die Steuereinheit einen Befehl zum Anlegen einer Spannung an die Elektroden derjenigen Polymerelemente 30 aus, welche die aktivierten Elektroden 26 und 28 zwischen sich einschließen. Hierzu kommt es zu einem Zusammendrücken des Polymers der Polymerelemente 30 zwischen den Elektroden und damit zu einer Verformung der elektrisch leitenden Schicht 14 und der Oberflächenschicht 12. Hierüber wird eine haptische Rückmeldung gegeben. Ein erneutes Drücken auf diesen Bereich führt dann wieder dazu, dass beispielsweise ein Bedienbefehl zum Abschalten einer Einheit erfasst wird und keine Spannung mehr an den Elektroden der Polymerelemente 30 anliegt, sodass diese wieder den in Fig. 4 gezeigten Zustand einnehmen.

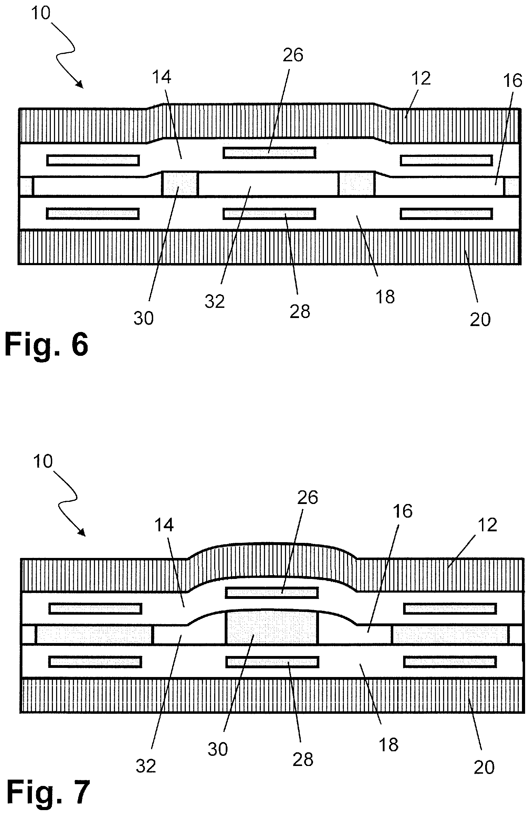

Fig. 6 zeigt eine schematische Darstellung des Schichtaufbaus der Folie 10 der vierten Ausführungsform nach einer Bedieneingabe mit haptischer Rückmeldung. Die Polymerelemente 30 haben sich durch Anlegen einer Spannung zusammengezogen, sodass es zu einer Verdickung der Abstandsschicht 16 in diesem Bereich kommt. Aufgrund der flexiblen Ausbildung der ersten elektrisch leitenden Schicht 14 und der ersten Oberflächenschicht 12 führt dies auch zu einer Erhebung im Bereich der Elektrode 26.

Diese Stellung wird solange aufrechterhalten, solange Spannung an den Elektroden der Polymerelemente 30 anliegt. Liegt keine Spannung mehr an, so gehen die Polymerelemente 30 wieder in ihre Ausgangsstellung (siehe Fig. 4) zurück. Dies kann beispielsweise dann erfolgen, wenn in einem aktivierten Zustand (Fig. 6) eine Bedienperson mittels eines Fingers 40 wieder auf den Bereich mit der Elektrode 26 drückt. Die Elektrode 26 verändert daher ihren Abstand zu der gegenüberliegenden Elektrode 28, was von der dazugehörigen Steuereinheit als Kapazitätsänderung erfasst wird. Dies wird als Bedienbefehl erfasst. In Folge dessen kann ein aktiver Zustand beendet werden und beispielsweise eine zugehörige Einheit einen anderen Zustand einnehmen. An den Elektroden der Polymerelemente 30 liegt dann keine Spannung mehr an, da die Steuereinheit die Versorgung unterbricht, wodurch die Ausgangsstellung (Fig. 4) wieder eingenommen wird.

Fig. 7 zeigt eine schematische Darstellung des Schichtaufbaus einer Folie 10 einer fünften Ausführungsform nach einer Bedieneingabe mit haptischer Rückmeldung.

In dieser Ausführungsform befinden sich die Polymerelemente 30 kongruent zu den Elektroden 26 und 28. Bei einer Aktivierung der Polymerelemente 30 kommt es daher zur Ausbildung einer Erhebung in der Folie 10 durch die erste elektrisch leitende Schicht 14 und die erste Oberflächenschicht 12. Diese sind flexibel ausgebildet und können daher durch das Polymerelement 30 verlagert werden. Entsprechend können die Oberflächenschicht 12 und die leitende Schicht 14 auch durch einen Finger 40 einer Bedienperson leicht nach unten gedrückt werden, sodass diese Abstandsänderung als kapazitive Änderung durch die Elektroden 26 und 28 erfasst werden kann. Dies wird als Bedienbefehl von einer damit gekoppelten Steuereinheit erfasst, welche wiederrum eine entsprechende Einheit ansteuert. Zudem bewirkt die Steuereinheit ein Anlegen der Spannung an die Elektroden des Polymerelementes 30, welche sich zwischen den Elektroden 26 und 28 befindet. Dies führt zu einer dargestellten Erhöhung im Bereich der Elektroden 26 und 28. Eine solche Verdickung des Polymerelementes 30 kann beispielsweise dadurch erreicht werden, dass die Elektroden sich orthogonal zur Längsrichtung der Elektroden 26 und 28 erstrecken, sodass beim Anlegen einer Spannung die Elektroden aufeinander zu bewegt werden.

Bei der vierten und fünften Ausführungsform verlaufen die Elektroden im Wesentlichen parallel durch die Abstandsschicht 16. In weiteren Ausführungsformen kann die Abstandsschicht 16 auch zusätzliche Polymerelemente 30 aufweisen, welche die in den Figuren gezeigten Polymerelemente 30 kreuzen. In weiteren Ausführungsformen können die Polymerelemente 30 auch nur bereichsweise vorgesehen sein und beispielsweise eine quaderförmige Erstreckung aufweisen. In weiteren Ausführungsformen können die Polymerelemente 30 auch als zylinderförmige Ausnehmungen in einer flexiblen Abstandsschicht aufgenommen sein.

Zusätzlich kann bei den in den Figuren gezeigten Ausführungsformen mindestens eine Beleuchtungsschicht mit OLEDs oder aus einem Lichtleiter vorgesehen sein. Solche Beleuchtungsschichten ermöglichen es Anzeigen von Funktionselementen, welche durch die gegenüberliegenden Elektroden gebildet werden, zu visualisieren. In weiteren Ausführungsformen kann auch eine akustische Einheit mit der Steuereinheit gekoppelt sein, welche die Folie 10 ansteuert und Bedienbefehle von dieser empfängt. So kann nach dem Auswählen eines Bedienbefehls eine akustische Rückmeldung gegeben werden.

### Bezugszeichenliste

- 10: Folie
- 12: Oberflächenschicht
- 14: leitende Schicht
- 16: Abstandsschicht
- 18: leitende Schicht
- 20: Oberflächenschicht
- 22: Beleuchtungsschicht
- 24: zweite Abstandsschicht
- 26: Elektrode
- 28: Elektrode
- 30: Polymerelement
- 32: Lücke
- 40: Finger

## Patentansprüche

1. Folie mit Funktionsschicht und haptischer Rückmeldung, wobei die Funktionsschicht mindestens zwei beabstandet gegenüberliegende Elektroden (26, 28) aufweist, wobei eine Elektrode (26) in einer ersten elektrisch leitenden Schicht (14) und eine Elektrode (28) in einer zweiten elektrisch leitenden Schicht (18) angeordnet oder durch diese gebildet sind, aufweisend folgenden Schichtaufbau:
- eine erste Oberflächenschicht (12),
- die erste elektrisch leitende Schicht (14),
- eine Abstandsschicht (16),
- die zweite elektrisch leitende Schicht (18), und
- eine zweite Oberflächenschicht (20),
wobei
- die Abstandsschicht (16) elektroaktive Polymere aufweist,
- die Abstandsschicht (16) zwischen der ersten elektrisch leitenden Schicht (14) und der zweiten elektrisch leitenden Schicht (18) angeordnet ist,
- über die Elektroden (26, 28) der ersten elektrisch leitenden Schicht (14) und der zweiten elektrisch leitenden Schicht (18) Bedieneingaben durch eine Kapazitätsänderung aufgrund der Veränderung des Abstands der elektrisch leitenden Schichten (14, 18) erfassbar sind, und
- die erste Oberflächenschicht (12) und die erste elektrisch leitende Schicht (14) zur Erzeugung einer haptischen Rückmeldung nach einer Bedieneingabe zur Wahrnehmung einer erfolgreichen Betätigung über die elektroaktiven Polymere verformbar sind, wobei über die elektroaktiven Polymere durch Anlegen einer Spannung Erhebungen und/oder Vertiefungen in der ersten Oberflächenschicht (12) erzeugt werden.

2. Folie nach Anspruch 1, wobei zwischen der zweiten elektrisch leitenden Schicht (18) und der zweiten Oberflächenschicht (20) eine Beleuchtungsschicht (22) angeordnet ist.

3. Folie nach Anspruch 2, wobei zwischen der zweiten elektrisch leitenden Schicht (18) und der Beleuchtungsschicht (22) eine zweite Abstandsschicht (24) angeordnet ist.

4. Folie nach Anspruch 2 oder 3, wobei die Beleuchtungsschicht (22) lichtemittierende Dioden oder organische lichtemittierende Dioden aufweist oder als Lichtleiter ausgebildet ist.

5. Folie nach einem der Ansprüche 1 bis 4, wobei die Abstandschicht (16) und/oder die erste elektrisch leitende Schicht (14) und die zweite elektrisch leitende Schicht (18) mindestens abschnittsweise in Segmente unterteilt ist.

6. Folie nach einem der Ansprüche 1 bis 5, wobei die erste elektrisch leitende Schicht (14) und die zweite elektrisch leitende Schicht (18) eine Vielzahl von Elektroden (26, 28) aufweisen, die gegenüberliegend in der ersten elektrisch leitenden Schicht (14) und in der zweiten elektrisch leitenden Schicht (18) angeordnet sind.

7. Folie nach einem der Ansprüche 1 bis 6, wobei die Abstandschicht (16) eine Vielzahl von Polymerelementen (30) aufweist, die beabstandet zueinander angeordnet sind.

## Claims

1. Film with functional layer and haptic feedback, wherein the functional layer comprises at least two spaced-apart opposite electrodes (26, 28), wherein one electrode (26) is arranged in or formed by a first electrically conductive layer (14) and one electrode (26) is arranged in or formed by a second electrically conductive layer (18), comprising the following layer construction:
- a first surface layer (12);
- the first electrically conductive layer (14);
- a spacing layer (16);
- the second electrically conductive layer (18); and
- a second surface layer (20);
wherein
- the spacing layer (16) comprises electroactive polymers,
- the spacing layer (16) is arranged between the first electrically conductive layer (14) and the second electrically conductive layer (18),
- by way of the electrodes (26, 28) of the first electrically conductive layer (14) and the second electrically conductive layer (18) user inputs are detectable through a capacitance change due to change in spacing of the electrically conductive layers (14, 18), and
- the first surface layer (12) and the first electrically conductive layer (14) are deformable by way of the electroactive polymers for producing a haptic feedback, after a user input, for sensing of a successful actuation, wherein elevations and/or depressions are produced in the first surface layer (12) by way of the electroactive polymers through application of a voltage.

2. Film according to claim 1, wherein a lighting layer (22) is arranged between the second electrically conductive layer (18) and the second surface layer (20).

3. Film according to claim 2, wherein a second spacing layer (24) is arranged between the second electrically conductive layer (18) and the lighting layer (22).

4. Film according to claim 2 or 3, wherein the lighting layer (22) comprises light-emitting diodes or organic light-emitting diodes or is constructed as an optical conductor.

5. Film according to any one of claims 1 to 4, wherein the spacing layer (16) and/or the first electrically conductive layer (14) and the second electrically conductive layer (18) are divided at least regionally into segments.

6. Film according to any one of claims 1 to 5, wherein the first electrically conductive layer (14) and the second electrically conductive layer (18) comprise a plurality of electrodes (26, 28) arranged oppositely in the first electrically conductive layer (14) and the second electrically conductive layer (18).

7. Film according to any one of claims 1 to 6, wherein the spacing layer (16) comprises a plurality of polymer elements (30) arranged at a spacing from one another.

## Revendications

1. Feuille pourvue de couche fonctionnelle et de réponse haptique, dans laquelle la couche fonctionnelle présente au moins deux électrodes (26, 28) face à face à distance, dans laquelle une électrode (26) est disposée dans une première couche électriquement conductrice (14) et une électrode (28) est disposée dans une seconde couche électriquement conductrice (18), ou les électrodes sont formées par celles-ci, présentant la structure de couches suivante :
- une première couche superficielle (12),
- la première couche électriquement conductrice (14),
- une couche d'espacement (16),
- la seconde couche électriquement conductrice (18), et
- une seconde couche superficielle (20),
dans laquelle
- la couche d'espacement (16) présente des polymères électroactifs,
- la couche d'espacement (16) est disposée entre la première couche électriquement conductrice (14) et la seconde couche électriquement conductrice (18),
- des entrées de commande peuvent être détectées par un changement de capacité lié à la modification de l'espacement entre les couches électriquement conductrices (14, 18) par l'intermédiaire des électrodes (26, 28) de la première couche électriquement conductrice (14) et de la seconde couche électriquement conductrice (18), et
- la première couche superficielle (12) et la première couche électriquement conductrice (14) peuvent être déformées pour générer une réponse haptique après une entrée de commande servant à la perception d'un actionnement réalisé avec succès par l'intermédiaire des polymères électroactifs, dans laquelle des parties en relief et/ou des renfoncements sont produits dans la première couche superficielle (12) par l'intermédiaire des polymères électroactifs par l'application d'une tension.

2. Feuille selon la revendication 1, dans laquelle une couche d'éclairage (22) est disposée entre la seconde couche électriquement conductrice (18) et la seconde couche superficielle (20).

3. Feuille selon la revendication 2, dans laquelle une deuxième couche d'espacement (24) est disposée entre la seconde couche électriquement conductrice (18) et la couche d'éclairage (22).

4. Feuille selon la revendication 2 ou 3, dans laquelle la couche d'éclairage (22) présente des diodes électroluminescentes ou des diodes électroluminescentes organiques, ou est réalisée en tant que guide de lumière.

5. Feuille selon l'une quelconque des revendications 1 à 4, dans laquelle la couche d'espacement (16) et/ou la première couche électriquement conductrice (14) et la seconde couche électriquement conductrice (18) sont divisées au moins par endroits en segments.

6. Feuille selon l'une quelconque des revendications 1 à 5, dans laquelle la première couche électriquement conductrice (14) et la seconde couche électriquement conductrice (18) présentent une pluralité d'électrodes (26, 28), qui sont disposées face à face dans la première couche électriquement conductrice (14) et dans la seconde couche électriquement conductrice (18).

7. Feuille selon l'une quelconque des revendications 1 à 6, dans laquelle la couche d'espacement (16) présente une pluralité d'éléments en polymère (30), qui sont disposés de manière espacée les uns des autres.
